# FASCICULE DE BREVET EUROPEEN

(11) **EP 4 038 661 B1**
(45) Date de publication et mention de la délivrance du brevet: **08.11.2023**
(21) Numéro de dépôt: 20780228.1
(22) Date de dépôt: 01.10.2020
(51) Int. Cl.: H01L 23/373, G01K 11/14

(54) **UTILISATION D'UN MATÉRIAU À TRANSITION DE SPIN POUR MESURER ET/OU LIMITER LA TEMPÉRATURE DE COMPOSANTS ÉLECTRONIQUES/PHOTONIQUES**
VERWENDUNG EINES SPIN-ÜBERGANGSMATERIALS ZUR MESSUNG UND / ODER BEGRENZUNG DER TEMPERATUR VON ELEKTRONISCHEN/FOTONISCHEN BAUTEILEN
USE OF A SPIN TRANSITION MATERIAL TO MEASURE AND/OR LIMIT THE TEMPERATURE OF ELECTRONIC/PHOTONIC COMPONENTS

(30) Priorité: 01.10.2019 FR 1910886
(43) Date de publication de la demande: 10.08.2022
(73) Titulaire: Centre national de la recherche scientifique, 75016 Paris (FR)
(72) Inventeur: BOUSSEKSOU, Azzedine, 31077 TOULOUSE Cédex 4 (FR); SALMON, Lionel, 31077 TOULOUSE Cédex 4 (FR); MOLNAR, Gabor, 31077 TOULOUSE Cédex 4 (FR); BERGAUD, Christian, 31077 TOULOUSE Cédex 4 (FR); RIDIER, Karl, 31077 TOULOUSE Cédex 4 (FR); QUINTERO, Carlos, 31077 TOULOUSE Cédex 4 (FR)
(74) Mandataire: Lavoix
(86) Numéro de dépôt international: PCT/EP2020/077495
(87) Numéro de publication internationale: WO 2021/064094

(56) Documents cités:
- OLENA KRAIEVA ET AL: "High Spatial Resolution Imaging of Transient Thermal Events Using Materials with Thermal Memory", SMALL, vol. 12, no. 46, 1 décembre 2016 (2016-12-01), pages 6325-6331, XP055703502, ISSN: 1613-6810, DOI: 10.1002/smll.201601766 cité dans la demande

## Description

La présente invention concerne la mesure et la limitation de la température (pour éviter les phénomènes de surchauffe) dans les composants électroniques.
Dans le domaine de la microélectronique, avec le développement des nouvelles technologies et l'augmentation des débits de télécommunication, il y a clairement un besoin grandissant (1) pour la détection rapide de « points chauds » (diagnostic industriel) pouvant détériorer la performance de ces dispositifs et (2) pour le développement de solutions simples pour en limiter les conséquences. En effet, actuellement, la surchauffe des composants électroniques constitue un problème majeur affectant de nombreuses cartes électroniques implantées dans divers appareils comme les serveurs, les ordinateurs, les tablettes, les téléphones portables et les objets connectés pour ne citer qu'eux. Les conséquences de cette surchauffe peuvent aller d'un simple ralentissement des logiciels, à une panne et même à la détérioration irréversible des appareils dans le pire des cas. Il existe donc un fort besoin dans le domaine de la microélectronique pour analyser et limiter la surchauffe des composants.

La mesure de la température sur les dispositifs électroniques est généralement effectuée par thermographie infrarouge, thermoréflectance, microscopie Raman, microscopie thermique à balayage ou thermométrie par fluorescence.
La limitation de la température des composants (aussi appelée l'inertie thermique) est typiquement réalisée par l'utilisation de systèmes de refroidissement afin de pallier aux problèmes de surchauffe. On trouve notamment des systèmes de refroidissement à air, à eau ou des matériaux à changement de phase solide-liquide (MCP). Les systèmes de refroidissement à air sont les plus couramment utilisés. Il en existe deux types : passif et actif. Le système passif est composé d'un simple radiateur qui facilite la libre circulation de l'air près des éléments chauffants. Dans la majorité des cas, ce système ne suffit pas et il est associé à un ventilateur (système actif) qui évacue l'air chaud à l'extérieur du boitier d'un ordinateur par exemple. Un circuit à eau ou à fluide frigorigène permet de limiter la hausse de température au sein du boitier. Ces systèmes à eau ou à changement de phase apparaissent trop coûteux, dangereux et souvent peu adaptés à cause de problèmes d'étanchéité pour être utilisés très largement dans les appareils électroniques destinés au grand public. De plus, outre le fait qu'ils soient trop encombrants pour être intégrés dans certains ordinateurs portables ultraplats ou tablettes, ces systèmes s'avèrent peu efficaces.

Il n'existe pas de solution simple, stable et peu coûteuse pour réaliser de façon intégrée une mesure d'élévation de température rapide et/ou une limitation de celle-ci. Il existe donc un réel besoin de trouver un système intégrable, peu encombrant et flexible (sans forme prédéfinie) afin de sonder et d'éviter la surchauffe des composants électroniques présents dans les objets du quotidien.

Les articles J. Mater. Chem., 2010, 20, 5499-5503, J. Mater. Chem., 2012, 22, 3745, Small, 2016, 12, 6325, et les proceedings du 16TH INTERNATIONAL WORKSHOP ON THERMAL INVESTIGATIONS OF ICS AND SYSTEMS, octobre 2010 rapportent la possibilité d'utiliser un matériau à transition de spin (éventuellement en le combinant avec une sonde fluorescente) pour des applications dans le domaine de la micro- et nano-thermométrie.

Néanmoins, il reste à mettre à oeuvre pour ces applications un matériau présentant des propriétés exceptionnelles de stabilité thermique et de résilience lors de sa mise en forme et de son cyclage thermique, dont les propriétés énergétiques combinées aux propriétés de transition thermique permettent son utilisation à titre de sonde thermique et de limitation de température.

Il a maintenant été découvert que ces utilisations pouvaient être mises en oeuvre avec un matériau à transition de spin, présentant des propriétés spécifiques, notamment de mise en forme, de résilience et de stabilité thermique, permettant les applications visées.

Ainsi, selon un premier objet, la présente invention concerne donc un composant électronique ou photonique comprenant un film déposé sur tout ou partie dudit composant, ledit film comprenant un matériau à transition de spin, caractérisé en ce que le matériau à transition de spin présente les propriétés suivantes :
a. Ledit matériau présente une transition de spin à une température comprise entre 40 et 100°C avec une largeur d'hystérésis inférieure à 1°C,
b. La stabilité de ladite température de transition de spin au cyclage est supérieure à 10 000 cycles thermiques avec une reproductibilité inférieure ou égale à 1°C;
c. Ledit matériau est sublimable.

Le phénomène de transition de spin s'accompagne d'un changement des propriétés optiques (absorption, indice optique), magnétiques, mécaniques et diélectriques, permettant, dans le cas de matériaux thermochromes, un changement de couleur significatif et réversible sous l'effet d'une variation de température. Il s'agit d'une transition réversible entre les états électroniques bas-spin et haut-spin qui se produit au sein de certains complexes de métaux de transition, et qui correspond à une reconfiguration électronique intramoléculaire. Par ailleurs, le passage de l'état bas-spin vers l'état haut-spin est un processus endothermique (le composé emmagasine de la chaleur).

Il s'agit donc d'utiliser un composé à transition de spin en particulier dans le domaine de la microélectronique, pour d'une part (1) sonder localement la température de composants électroniques en fonctionnement et notamment une élévation indésirable de température par une mesure (imagerie) optique (micro-thermométrie) et d'autre part (2) limiter/amortir cette augmentation de température en utilisant les propriétés endothermiques intrinsèques du matériau (inertie thermique) ; ces deux applications pouvant être réalisées simultanément avec le même matériau dit multifonctionnel.

L'invention concerne la mise en oeuvre dudit matériau à transition de spin pour mesurer (thermométrie) et limiter (inertie thermique) une élévation de température notamment dans le domaine de l'électronique.

Typiquement, les matériaux à transition de spin pouvant convenir à l'invention présentent une température à transition de spin comprise entre 40°C et 100°C, notamment entre 50 et 70°C.

Avantageusement, ledit matériau à transition de spin est [Fe(HB(1,2,4-triazol-1-yl)₃)₂], bis[hydrotris(1,2,4-triazol-1-yl)borate]fer(II). La synthèse de ce matériau a été publiée en 1994 (Chem. Ber., 1994, 127, 1379) et les propriétés de transition de spin mesurées en 1996 (Chem. Eur. J., 1996, 2, 992-1000). Néanmoins, l'application de ce matériau dans le domaine de la microélectronique n'avait jamais été considérée.

Ce matériau présente une température de transition de spin Tmax = 62°C, idéale pour la détection des points chauds en microélectronique, avec une transition abrupte le rendant ainsi compatible avec des mesures thermométriques, associé, de façon inattendue, à une stabilité thermique et une non-fatigabilité au cours de cycles thermiques répétés. Ce matériau est, de plus, sublimable, permettant ainsi son dépôt sur les composants.

Typiquement, les matériaux selon l'invention présentent une transition de spin abrupte.
Le caractère abrupte de la transition définit la plage de température sur laquelle s'opère chacune des transitions. On définit selon l'invention comme « abrupte » une transition dont 80% du changement de l'état de spin s'opère sur une gamme de température inférieure à 10°C.

La largeur de l'hystérésis définit l'écart de température entre les transitions bas spin vers haut spin (chauffage) et haut spin vers bas spin (refroidissement).

Avantageusement, selon l'invention, la transition de spin s'opère « sans hystérésis thermique », c'est-à-dire, telle que la largeur de l'hystérésis est typiquement inférieure à 1°C.

Selon un mode de réalisation, ledit matériau peut être déposé sous la forme d'une couche mince continue et homogène d'épaisseur comprise entre 10 nm et 10 µm, sur au moins une partie de la surface dudit composant.

Ledit matériau peut être sublimé de telle sorte que des films minces de quelques dizaines de nanomètres à plusieurs micromètres d'épaisseur peuvent être réalisés sur différents substrats/circuits. Ces films sont le siège d'une transition de spin stable et abrupte.

A titre de composant électronique ou photonique convenant à l'invention, on entend un élément destiné à être assemblé avec d'autres afin de réaliser une ou plusieurs fonctions électroniques ou photoniques, et qui est susceptible de subir une augmentation de température, lors de son fonctionnement. On peut notamment citer les composants passifs ou actifs, et plus particulièrement les diodes, transistors, circuits intégrés, résistances, condensateurs, bobines, etc. En ce qui concerne les composants photoniques, on peut citer les diodes laser et tout autre dispositif basé sur une ingénierie des indices optiques aux interfaces, conférant à ces derniers une grande sensibilité à toute variation de température.

Selon un autre objet, la présente invention concerne également un circuit électronique ou un dispositif photonique comprenant au moins un composant selon l'invention.

Selon un autre objet, la présente invention concerne également un procédé de préparation d'un composant selon l'invention comprenant l'étape de dépôt dudit matériau à transition de spin en couche mince, par exemple par sublimation ou spin coating, sur tout ou partie dudit composant. Le dépôt peut ainsi être effectué par la méthode décrite dans l'article J. Mater. Chem. C, 2017, 5, 4419, pour obtenir des films minces dans lesquels les propriétés de transition du matériau sont préservées.

Le dépôt par sublimation est une technique de dépôt en phase vapeur, sous vide, qui permet l'obtention d'une couche mince d'épaisseur contrôlée. Le dépôt par spin coating peut être effectué par application ou adaptation du procédé décrit dans EP 1 430 552.

Les conditions de dépôt ainsi que les propriétés intrinsèques dudit matériau sont non destructives pour les propriétés et les performances du composant et/ou circuit électronique ou photonique.

Selon un autre objet, la présente invention concerne également l'utilisation d'un matériau à transition de spin tel que défini ci-avant pour la mesure et/ou la limitation d'une élévation de température dans un composant et/ou circuit électronique ou photonique.

Pour ce qui concerne la mesure de l'augmentation de la température, l'utilisation selon l'invention repose sur la mesure d'une propriété optique du matériau à transition de spin. Ceci constitue une méthode simple, non invasive et rentable qui peut fournir une imagerie thermique avec une bonne résolution temporelle et spatiale. Ceci permet d'établir de façon précise et reproductible une cartographique thermique de nano-composants électroniques et/ou photoniques.

A titre de propriété optique, on peut notamment mesurer l'indice optique, la réflectivité optique ou l'absorbance optique.

Avantageusement, la mesure de la propriété optique peut être effectuée avec une résolution spatiale permettant d'atteindre quelques centaines de nanomètres (limite de diffraction).

Ainsi, selon un objet, la présente invention concerne un procédé de mesure d'une élévation de la température au-delà d'une température Tmax au sein d'un composant et/ou d'un circuit électronique ou photonique tel que défini ci-avant et tel que la température de transition de spin du matériau est égale à Tmax,
ledit procédé comprenant :
a. La mesure d'au moins une propriété optique dudit matériau lorsque ledit composant et/ou circuit est hors fonctionnement,
b. La mesure d'au moins une propriété optique dudit matériau lorsque ledit composant et/ou circuit est en fonctionnement,
c. L'identification des zones pour lesquelles ladite propriété optique varie par suite de la transition de spin dudit matériau.

Selon un mode de réalisation, les étapes b) et c) peuvent être répétées à différentes températures de base au-dessous de Tmax, en augmentant et/ou diminuant la température dudit composant et/ou circuit, et qu'une cartographie de la température dudit composant et/ou circuit est établie.

Pour ce qui concerne la limitation de l'augmentation de la température, l'utilisation selon l'invention repose sur les propriétés d'emmagasinement de la chaleur par ledit matériau pour amortir une élévation transitoire de température générée par un composant électronique en surchauffe à cause de son fonctionnement intensif ou s'il est défectueux. L'utilisation selon l'invention allie les avantages d'un système passif (technologie silencieuse non consommatrice en énergie) et l'efficacité d'un système actif. Le principe physique exploité est celui de la transition endothermique. Ce principe est généralement utilisé via les matériaux à changement de phase solide - liquide (MCP). Selon l'invention, ce principe est exploité avec un matériau moléculaire à transition de spin, sans changement d'état (fusion), et par conséquent, plus stable, plus viable (évitant des problèmes d'étanchéité) et également non inflammable.

Ainsi, selon un autre objet, la présente invention concerne un procédé de limitation de la température dans un composant et/ou circuit électronique ou photonique tel que défini ci-avant, en deçà d'une température Tmax, telle que Tmax est égale à la température de transition de spin dudit matériau,
ledit procédé comprenant :
a. La montée en température dudit composant et/ou circuit lors de son fonctionnement,
b. Lorsque ladite température atteint la valeur Tmax, ledit matériau subit une transition de spin endothermique vers la phase haut spin absorbant tout ou partie de l'énergie de surchauffe et limitant ainsi l'élévation de la température jusqu'à la transformation complète dudit matériau vers la phase haut-spin.

### Figures

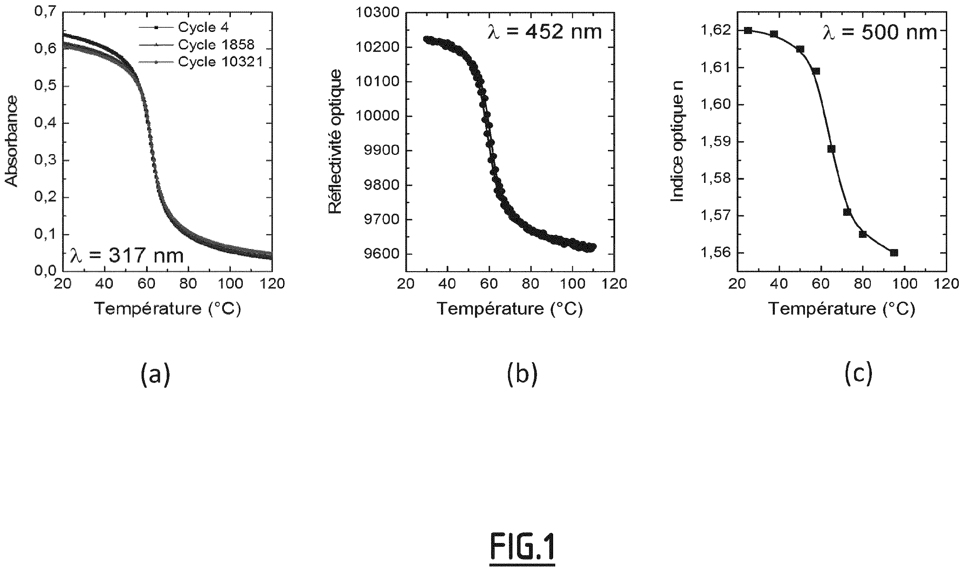

La Figure 1 représente l'évolution de propriétés optiques d'un film mince de [Fe(HB(1,2,4-triazol-1-yl)₃)₂] de 200 nm d'épaisseur en fonction de la température : (a) Absorption optique (λ = 317 nm) en fonction de la température mesurée après 4, 1858 et 10321 cycles thermiques. Ces mesures démontrent la grande résilience du matériau, dont la température de transition reste invariante (ΔT < 1°C) après plus de 10.000 cycles thermiques. (b) Réflectivité optique (λ = 452 nm) mesurée sur un film mince déposé sur un substrat de verre, montrant une variation relative de la réflectivité de -5,8 % lors de la transition de l'état bas-spin vers l'état haut-spin. (c) Variation de l'indice optique du film mince (mesurée à λ = 500 nm) en fonction de la température.

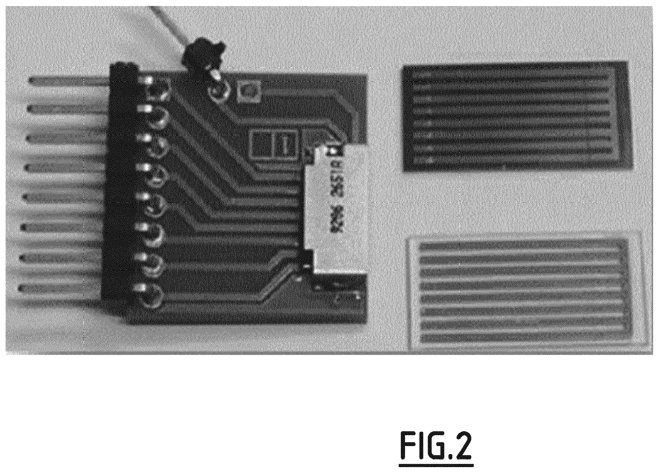

La Figure 2 représente une photographie du connecteur électrique (à gauche) et du dispositif d'essai utilisé dans l'exemple 1, consistant en un substrat (20 × 10 mm) de silicium (en haut à droite) ou de verre (en bas à droite) sur lesquels sont élaborés 7 nano-fils d'or.

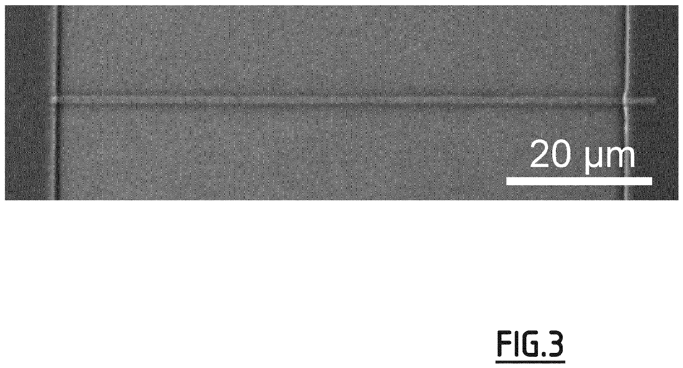

La Figure 3 représente une image en microscopie électronique à balayage d'un nano-fil d'or (largeur : 1 µm, longueur : 80 µm, épaisseur : 50 nm).

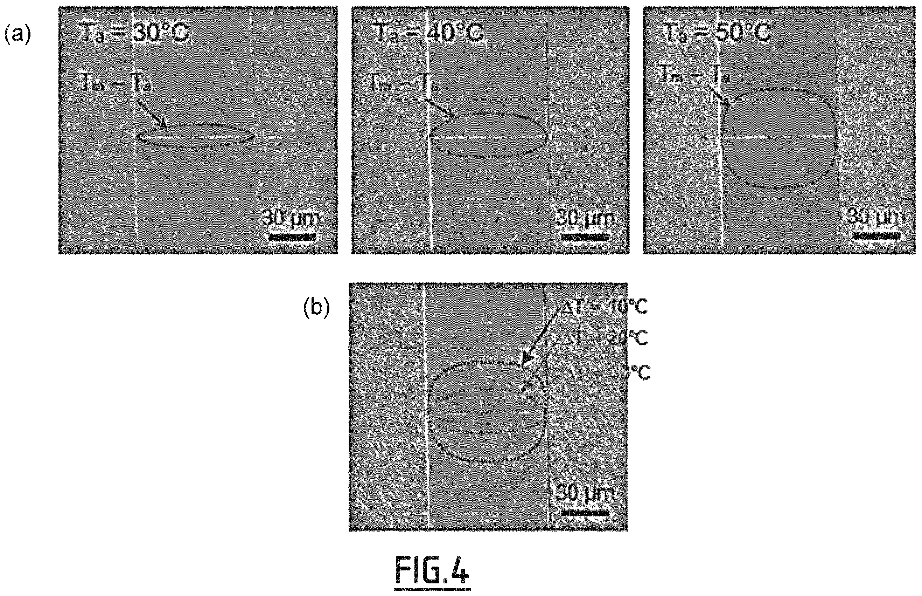

La Figure 4 illustre les mesures de thermométrie effectuées sur un nano-fil du dispositif d'essai recouvert par une couche de [Fe(HB(1,2,4-triazol-1-yl)₃)₂] de 200 nm d'épaisseur : (a) Images en réflectivité (λ = 452 nm) obtenues par microscopie optique du nano-fil en fonctionnement sur un substrat de verre (parcouru par un courant électrique de 4 mA) à différentes températures de base (Tₐ = 30°C, 40°C et 50°C) et tracé des lignes isothermes, (b) Carte de températures obtenue lors du fonctionnement du nano-fil d'or chauffé par effet Joule.

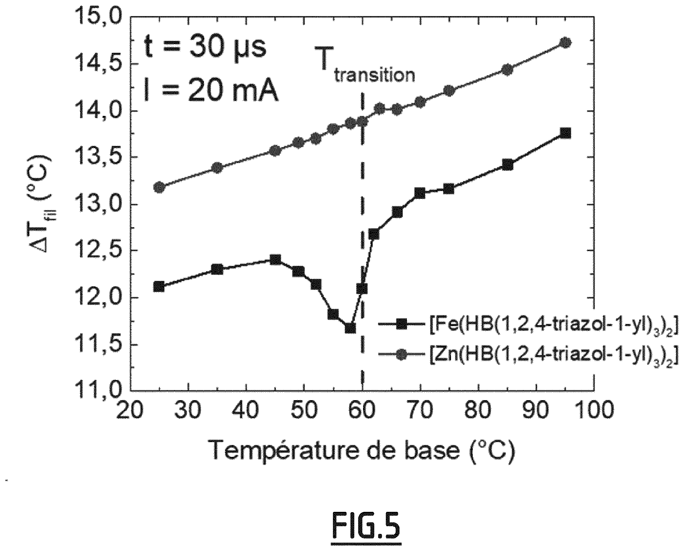

La Figure 5 illustre les mesures de limitation de température d'un nano-fil d'or du dispositif d'essai (substrat en verre) recouvert par une couche de [Fe(HB(1,2,4-triazol-1-yl)₃)₂] de 900 nm d'épaisseur : Evolution de ΔT_{fil}, mesuré 30 µs après l'injection du courant électrique de 20 mA, en fonction de la température de base pour le composé actif (complexe de Fe, [Fe(HB(1,2,4-triazol-1-yl)₃)₂]) ainsi que pour un composé similaire, mais inactif (complexe de Zn, [Zn(HB(1,2,4-triazol-1-yl)₃)₂]).

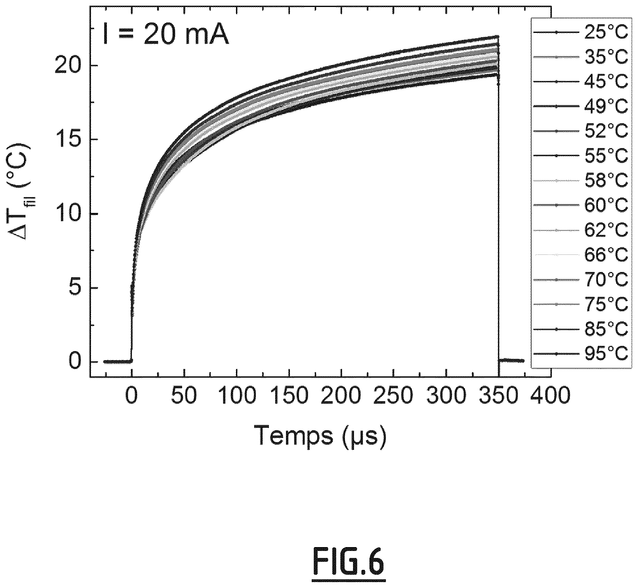

La Figure 6 représente l'élévation de la température (ΔT_{fil}) subit par un nano-fil d'or (sur un substrat de verre) au cours du temps suite à l'injection brusque d'un courant électrique de 20 mA pendant 350 µs, pour différentes températures de base du dispositif.

Les exemples suivants illustrent de façon non limitative la présente invention.

### Exemples

1. Préparation du matériau
   Ledit matériau est synthétisé suivant le protocole décrit dans l'article Chem. Ber., 1994, 127, 1379.
2. Dépôt sur un composant
   Le dépôt du film mince de [Fe(HB(1,2,4-triazol-1-yl)₃)₂] sur le dispositif d'essai a été effectué par évaporation thermique dans une chambre de dépôt sous vide PREVAC à une pression d'environ 2 × 10⁻⁷ mbar. La poudre du composé a d'abord été purifiée par sublimation, puis évaporée à 250°C à une vitesse de 0,03 Å / s. La vitesse d'évaporation et l'épaisseur du film ont été contrôlées *in situ* par une microbalance à quartz. Les films obtenus font ensuite l'objet d'un traitement sous vapeur d'eau qui permet d'obtenir des films nano-cristallins, stables et homogènes [J. Mater. Chem. C, 2017, 5, 4419].
3. Mise en évidence des propriétés thermométriques

Comme illustré en Figure 1, la transition du matériau s'accompagne d'un **changement significatif des propriétés optiques** du film mince, en particulier de l'absorbance optique (Figure 1a), de la réflectivité optique (Figure 1b) ou encore de l'indice optique (Figure 1c). Ceci permet l'utilisation de différentes techniques optiques pour détecter la transition de spin.

Cette transition s'accompagne également d'une **enthalpie de changement d'état (chaleur latente)** de l'ordre de 33 kJ/kg (transition endothermique lors du passage de l'état bas-spin vers l'état haut-spin (chauffage) et exothermique dans le cas contraire (refroidissement)). Cette dernière propriété peut donc être utilisée pour limiter significativement une augmentation transitoire de température.

Comme montré sur la Figure 1a, la température et les propriétés de transition des films minces dudit matériau ne sont pas significativement affectées même après plus de 10.000 cycles thermiques à l'air ambiant.

Une cartographie thermique d'un circuit électronique a été réalisée avec une résolution spatiale de l'ordre du micromètre par une série de mesures de réflectivité optique. Le protocole expérimental consiste à enregistrer l'image du dispositif recouvert dudit matériau sous microscope optique (en mode réflectivité) avant et après la mise sous tension du microcircuit.

Comme le montre la Figure 2, ce protocole expérimental a été validé sur un dispositif d'essai qui consiste en des nano-fils d'or (largeur : 1 µm, longueur : 80 µm, épaisseur : 50 nm) élaborés par lithographie électronique et photolithographie sur des substrats de silicium ou de verre. L'ensemble de ce dispositif a été recouvert par un film mince de 200 nm d'épaisseur dudit matériau, déposé par évaporation thermique sous vide. L'injection d'un courant électrique continu de 4 mA, à l'aide d'un source-mètre (Keithley 2611A) et d'un connecteur adapté, engendre l'échauffement du nano-fil par effet Joule. Des images du dispositif sont enregistrées en réflectivité (λ = 452 nm), avant et pendant son fonctionnement, grâce à un microscope optique (Olympus BX51) équipé d'un objectif ×50 (ouverture numérique NA = 0,5) et d'une caméra CCD (Andor Technology Clara, 1392 × 1040 pixels de taille 6,45 µm). Dans l'image de réflectivité optique du nano-fil en fonctionnement, deux zones sont alors discernables (Figure 3) : une zone, proche du fil, dont la réflectivité a changé lors de l'injection du courant et dont la température se trouve donc au-delà de la température de transition ; et une zone dont la réflectivité optique reste inchangée. Ces deux zones sont séparées par une ligne isotherme pour laquelle l'augmentation de température correspond exactement à la différence entre la température de transition dudit matériau (Tₘ) et la température ambiante (Tₐ). Un des avantages de cette méthode est que la détermination de l'augmentation de température sur cette ligne isotherme peut être réalisée sans aucune calibration préalable de la réflectivité. Par la suite, un chauffage ou un refroidissement de l'ensemble du microcircuit - ce dernier étant posé sur un système de chauffage/refroidissement (Linkam Scientific LTS 120) - à différentes `températures de base' Tₐ permet d'enregistrer autant de lignes isothermes que désirées. L'ensemble de ces lignes isothermes peut ensuite être regroupé dans une carte de températures (Figure 4).

### 4. Mise en évidence des propriétés d'inertie thermique

Cette propriété de 'limitation de température' a été démontrée sur le même dispositif d'essai consistant en un nano-fil d'or sur un substrat en verre, recouvert d'un film mince dudit matériau, et chauffé par effet Joule suite à l'injection brusque d'un courant électrique de 20 mA (Figures 5 et 6). Au cours de cette expérience, l'augmentation de température du fil a pu être déterminée précisément au cours du temps (avec une résolution temporelle de l'ordre de la µs) en mesurant la variation temporelle de la résistance électrique du fil (qui varie linéairement avec sa température) à l'aide d'un dispositif de mesure de résistance différentielle fabriqué sur mesure [Microelectronics Journal 46 (2015) 1167-1174]. Comme montré dans la Figure 6, l'élévation de température du fil ΔT_{fil} a pu être mesurée au cours du temps pour différentes températures de base du dispositif, contrôlées par un système de chauffage/refroidissement (Linkam Scientific LTS120). Comme le montre la Figure 5, l'échauffement du fil, mesuré 30 µs après l'injection du courant, montre un minimum lorsque la température de base du fil est proche de la température de transition. Cette réduction de l'échauffement du fil s'opère car une partie de la chaleur dégagée par le fil a été absorbée par le matériau à transition de spin. La même expérience réalisée lorsque le nano-fil est recouvert par un composé similaire mais inactif (complexe de Zn, [Zn(HB(1,2,4-triazol-1-yl)₃)₂]), montre un comportement linéaire dans l'échauffement du fil en fonction de la température de base (Figure 5).

## Revendications

1. Composant électronique ou photonique comprenant un film déposé sur tout ou partie dudit composant, ledit film comprenant un matériau à transition de spin, **caractérisé en ce que** le matériau à transition de spin présente les propriétés suivantes :
a. Ledit matériau présente une transition de spin à une température comprise entre 40 et 100°C avec une largeur d'hystérésis inférieure à 1°C,
b. La stabilité de ladite température de transition de spin au cyclage est supérieure à 10 000 cycles thermiques avec une reproductibilité inférieure ou égale à 1°C;
c. Ledit matériau est sublimable.

2. Composant selon la revendication 1 tel que ledit matériau à transition de spin est [Fe(HB(1,2,4-triazol-1-yl)₃)₂].

3. Composant selon la revendication 1 ou 2 tel que ledit matériau est déposé sous la forme d'une couche mince continue et homogène d'épaisseur comprise entre 10 nm et 10 µm, sur au moins une partie de sa surface.

4. Circuit électronique ou dispositif photonique comprenant au moins un composant selon l'une quelconque des revendications 1 à 3.

5. Procédé de préparation d'un composant selon l'une quelconque des revendications 1 à 3 comprenant l'étape de dépôt dudit matériau par sublimation ou spin coating sur tout ou partie dudit composant.

6. Utilisation d'un matériau à transition de spin tel que défini en revendication 1 ou 2 pour la mesure et/ou la limitation d'une élévation de température dans un composant et/ou circuit électronique ou photonique.

7. Procédé de limitation de la température dans un composant et/ou circuit électronique ou photonique tel que défini selon l'une quelconque des revendications 1 à 4, en deçà d'une température Tmax, telle que Tmax est égale à la température de transition de spin dudit matériau,
ledit procédé comprenant :
a. La montée en température dudit composant et/ou circuit lors de son fonctionnement,
b. Lorsque ladite température atteint la valeur Tmax, ledit matériau subit une transition de spin endothermique vers la phase haut spin absorbant tout ou partie de l'énergie de surchauffe et limitant ainsi l'élévation de la température jusqu'à la transformation complète dudit matériau vers la phase haut-spin.

8. Procédé de mesure d'une élévation de la température au-delà d'une température Tmax au sein d'un composant et/ou d'un circuit électronique ou photonique tel que défini selon l'une quelconque des revendications 1 à 4 et tel que la température de transition de spin du matériau est égale à Tmax,
ledit procédé comprenant :
a. La mesure d'au moins une propriété optique dudit matériau lorsque ledit composant et/ou circuit est hors fonctionnement,
b. La mesure d'au moins une propriété optique dudit matériau lorsque ledit composant et/ou circuit est en fonctionnement,
c. L'identification des zones pour lesquelles ladite propriété optique varie par suite de la transition de spin dudit matériau.

9. Procédé selon la revendication 8 tel que les étapes b) et c) sont répétées à différentes températures de base au-dessous de Tmax, en augmentant et/ou diminuant la température dudit composant et/ou circuit, et qu'une cartographie de la température dudit composant et/ou circuit est établie.

10. Procédé selon la revendication 8 ou 9 tel qu'on mesure une ou plusieurs propriétés optiques choisies parmi l'indice optique, la réflectivité optique et l'absorbance optique.

## Patentansprüche

1. Elektronische oder photonische Komponente, umfassend einen Film umfasst, der auf der gesamten Komponente oder einem Teil davon aufgebracht ist, wobei der Film ein Spin-Übergangsmaterial umfasst, **dadurch gekennzeichnet, dass** das Spin-Übergangsmaterial die folgenden Eigenschaften aufweist:
a. das genannte Material weist bei einer Temperatur zwischen 40 und 100 °C einen Spin-Übergang mit einer Hysteresebreite von weniger als 1 °C auf,
b. die Stabilität der genannten Spin-Übergangstemperatur beim Zyklieren ist mehr als 10.000 thermische Zyklen mit einer Reproduzierbarkeit von 1 °C oder weniger;
c. das Material ist sublimierbar.

2. Komponente nach Anspruch 1, wobei das Spin-Übergangsmaterial [Fe(HB(1,2,4-triazol-1-yl)₃)₂] ist.

3. Komponente nach Anspruch 1 oder 2, wobei das Material in Form einer kontinuierlichen und homogenen dünnen Schicht mit einer Stärke zwischen 10 nm und 10 µm auf mindestens einem Teil seiner Oberfläche aufgebracht ist.

4. Elektronische Schaltung oder photonische Vorrichtung, umfassend mindestens eine Komponente nach einem der Ansprüche 1 bis 3.

5. Verfahren zur Herstellung einer Komponente nach einem der Ansprüche 1 bis 3, umfassend den Schritt eines Aufbringens des Materials durch Sublimation oder Spin-Beschichtung auf die gesamte oder einen Teil der Komponente.

6. Verwendung eines Spin-Übergangsmaterials wie definiert in Anspruch 1 oder 2 zum Messen und/oder Begrenzen eines Temperaturanstiegs in einer elektronischen oder photonischen Komponente und/oder Schaltkreis.

7. Verfahren zum Begrenzen der Temperatur in einer elektronischen oder photonischen Komponente und/oder Schaltkreis, wie definiert nach einem der Ansprüche 1 bis 4 unterhalb einer Temperatur Tmax, sodass Tmax gleich wie die Spin-Übergangstemperatur des Materials ist, das Verfahren umfassend:
a. den Temperaturanstieg der Komponente und/oder Schaltung während ihres/seines Betriebs,
b. wenn die Temperatur den Wert Tmax erreicht, durchläuft das Material einen endothermen Spin-Übergang zur Hochspinphase, wobei die gesamte oder ein Teil der Überhitzungsenergie absorbiert wird und somit der Temperaturanstieg begrenzt wird, bis das Material vollständig in die Hochspinphase umgewandelt ist.

8. Verfahren zum Messen eines Temperaturanstiegs über eine Temperatur Tmax hinaus innerhalb einer elektronischen oder photonischen Komponente und/oder Schaltkreises, wie definiert nach einem der Ansprüche 1 bis 4, und dass die Spin-Übergangstemperatur des Materials gleich wie Tmax ist, das Verfahren umfassend:
a. Messen mindestens einer optischen Eigenschaft des Materials, wenn die Komponente und/oder der Schaltkreis außer Betrieb ist,
b. Messen mindestens einer optischen Eigenschaft des Materials, wenn die Komponente und/oder der Schaltkreis in Betrieb ist,
c. Identifizieren von Bereichen, in denen sich die genannte optische Eigenschaft als Folge des Spin-Übergangs des Materials ändert.

9. Verfahren nach Anspruch 8, wobei die Schritte b) und c) bei verschiedenen Basistemperaturen unterhalb von Tmax wiederholt werden, wobei die Temperatur der Komponente und/oder der Schaltung erhöht und/oder verringert wird, und wobei eine Abbildung der Temperatur der Komponente und/oder der Schaltung erstellt wird.

10. Verfahren nach Anspruch 8 oder 9, wobei eine oder mehrere optische Eigenschaften gemessen werden, die ausgewählt sind aus dem optischen Index, dem optischen Reflexionsvermögen und dem optischen Absorptionsvermögen.

## Claims

1. An electronic or photonic component comprising a film deposited over all or part of said component, said film comprising a spin transition material, **characterized in that** the spin transition material has the following properties:
a. Said material has a spin transition at a temperature of between 40 and 100°C with a hysteresis width less than 1°C,
b. The stability of said spin transition temperature on cycling is greater than 10,000 thermal cycles with a reproducibility less than or equal to 1°C;
c. Said material is sublimable.

2. The component according to claim 1, such that said spin transition material is [Fe(HB(1,2,4-triazol-1-yl)₃)₂].

3. The component according to claim 1 or 2, such that said material is deposited in the form of a continuous and uniform thin layer with a thickness of between 10 nm and 10 µm, over at least part of its surface.

4. An electronic circuit or photonic device comprising at least one component according to any one of claims 1 to 3.

5. A method for preparing a component according to any one of claims 1 to 3, comprising the step of depositing said material by sublimation or spin coating on all or part of said component.

6. Use of a spin transition material as defined in claim 1 or 2 to measure and/or limit a temperature increase in an electronic or photonic component and/or circuit.

7. A method for limiting the temperature in an electronic or photonic component and/or circuit as defined according to any one of claims 1 to 4, below a temperature Tmax, such that Tmax is equal to the spin transition temperature of said material,
said method comprising:
a. The temperature increase of said component and/or circuit during its operation,
b. When said temperature reaches the value Tmax, said material undergoes an endothermic spin transition toward the high-spin phase absorbing all or part of the overheating energy and thus limiting the temperature increase until the complete transformation of said material toward the high-spin phase.

8. A method for measuring a temperature increase beyond a temperature Tmax within an electronic or photonic component and/or circuit as defined according to any one of claims 1 to 4 and such that the spin transition temperature of the material is equal to Tmax,
said method comprising:
a. Measuring at least one optical property of said material when said component and/or circuit is off,
b. Measuring at least one optical property of said material when said component and/or circuit is on,
c. Identifying zones for which said optical property varies following the spin transition of said material.

9. The method according to claim 8, such that steps b) and c) are repeated at different base temperatures below Tmax, by increasing and/or decreasing the temperature of said component and/or circuit, and a map of the temperature of said component and/or circuit is established.

10. The method according to claim 8 or 9, such that one or several optical properties are measured chosen from among the optical index, the optical reflectivity and the optical absorbency.
